# EUROPEAN PATENT APPLICATION

(11) **EP 1 635 394 A1**
(43) Date of publication of application: **15.03.2006**
(21) Application number: 04745815.3
(22) Date of filing: 11.06.2004
(51) Int. Cl.: H01L 27/092, H03F 3/34, H03F 3/45, H01L 29/78, H01L 21/336

(54) **DC AMPLIFIER AND SEMICONDUCTOR INTEGRATED CIRCUIT THEREOF**

(30) Priority: 13.06.2003 JP 2003170104
(71) Applicant: KABUSHIKI KAISHA TOYOTA JIDOSHOKKI, Kariya-shi, Aichi 448-8671 (JP); Niigata Seimitsu Co., Ltd., Niigata 943-0834 (JP); OHMI, Tadahiro, Sendai-shi, Miyagi 980-0813 (JP)
(72) Inventor: OHMI, Tadahiro, 1-17-301, Komegahukuro 2-chome,, Miyagi 9800813 (JP); NISHIMUTA, T., KABUSHIKI KAISHA TOYOTA JIDOSHOKKI, Aichi 4488671 (JP); MIYAGI, Hiroshi, c/o NIIGATA SEIMITSU CO., LTD.,, Joetsu-shi, Niigata 9430834 (JP); SUGAWA, Shigetoshi, 35-2-102,Kawauchimotohasekura, Miyagi 9800861 (JP); TERAMOTO, Akinobu, 1-22-K6, Heisei 1-chome,Miyagi, Miyagi 9830037 (JP)
(74) Representative: TBK-Patent
(86) International application number: PCT/JP2004/008221
(87) International publication number: WO 2004/112144

(57) **Abstract**

A rectangular parallelepiped projecting portion 21 having a height of H_{B} and a width of W_{B} is formed on a silicon substrate, and a gate oxide film is formed on a part of the top surface and the side surface of the projecting portion 21. A source and a drain are formed on both sides of the gate electrode 26 to form a MOS transistor. The MOS transistor configures a DC amplifier. The DC amplifier includes a differential amplification circuit having MOS transistors 61 and 62, thereby realizing a high-gain DC amplifier.

## Description

### Technical Field

The present invention relates to a DC amplifier formed on the substrate of a semiconductor integrated circuit, and the semiconductor integrated circuit for the DC amplifier.

### Background Art..

In the conventional production process of a MOS transistor, a thermal oxide film is formed on the silicon surface in a high temperature environment of 800°C, and a MOS transistor is produced using a thermal oxide film as a gate insulating film.

It is requested to form an oxide film in a lower temperature environment to enhance the production efficiency of a semiconductor. To realize this request, for example, the patent document 1 discloses the technology of forming an insulating film in a low temperature plasma atmosphere.

In the wireless communication field of mobile telephones, etc., a circuit is integrated to achieve smaller and lower cost equipment.

To demodulate a radio signal, there is a super heterodyne system of converting a received signal to an intermediate frequency, amplifying the frequency, and converting the result to a baseband signal, and a direct conversion system of converting a received signal directly to a baseband signal.

The direct conversion system requires no filter, etc. for removing an image generated when conversion to an intermediate frequency signal is performed. Therefore, a receiver can be configured with a simpler circuit.

In a direct conversion receiver, it is necessary for a mixer to mix local oscillation signals having 90° phase difference from a received signal, convert the obtained signals to two baseband signals having phases orthogonal to each other, and then amplify the baseband signals with a DC amplifier.

However, since the output signal of the mixer contains a DC offset, the DC offset is also amplified by the DC amplifier, thereby causing a problem that amplitude gain of a baseband signal cannot be sufficiently obtained.

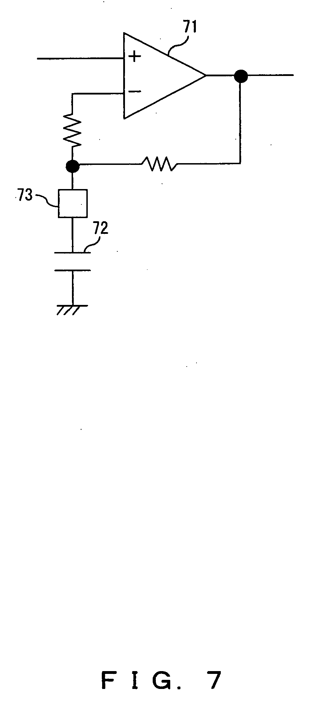

To solve the problem, an example is shown in Fig. 7. A circuit for connecting a capacitor 72 of a relatively large capacity to absorb the DC offset to the input side of an operational amplifier 71 is demonstrated.
Patent Document 1: Japanese Published Patent Application No. 2002-261091 (Fig. 1, paragraph 0022, etc.)
Patent Document 2: Japanese Published Patent Application No. 2002-217769

Since it is hard to form the capacitor 72 with a capacity large enough to remove the DC offset shown in Fig. 7 on the substrate of an integrated circuit, an external capacitor is used. By using an external capacitor, it is necessary to provide a terminal 73 for connecting the capacitor to the semiconductor integrated circuit, and the number of external terminals available as input/output terminals of a signal decreases. Therefore, as the number of necessary terminals is increased, the size of the entire system with the external capacitor becomes problematic. By using the external capacitor components cost is increased.

When a MOS transistor in a direct conversion receiver configures a DC amplifier, the MOS transistor has higher 1/f noise than a bipolar transistor. Accordingly, it is necessary to take measures to reduce the 1/f noise.

### Disclosure of the Invention

The present invention aims at realizing a high-gain DC amplifier, and also aims at reducing the distortion of the signal in the DC amplifier.

The DC amplifier according to the present invention is formed on the substrate of a semiconductor integrated circuit, and includes a differential amplification circuit. This includes an MIS field-effect transistor in which a projecting portion is formed by a silicon substrate having a first crystal surface as a primary surface and a second crystal surface as a side surface. Terminated hydrogen on the silicon surface is removed in a plasma atmosphere of an inert gas, and a gate insulating film is formed on at least a part of the top surface and the side surface of the projecting portion at a temperature at or lower than approximately 550°C in the plasma atmosphere. A gate is formed on the gate insulating film, and a drain and a source are formed on both sides enclosing the gate insulating film of the projecting portion.

According to the invention, by decreasing the damage of the silicon substrate and enhancing the evenness, the variance of the features (for example, a threshold voltage, etc.) of the MIS field-effect transistor can be reduced. Thus, the DC offset and 1/f noise generated in the DC amplifier can be decreased. Therefore, the gain of the DC amplifier can be increased, and the frequency characteristic of the DC amplifier can be improved. As a result, a circuit to compensating for the DC offset is not required.

Additionally, by generating a three-dimensional gate, and forming a gate insulating film in a low plasma atmosphere, the effect of channel length modulation can be reduced, and the distortion of a signal in the DC amplifier can be decreased.

Furthermore, by forming a gate insulating film on a different crystal surface, the current drive capability of a MIS field-effect transistor can be improved and the device area of the MIS field-effect transistor on the primary surface of a silicon substrate can be made smaller.

In the above-mentioned invention, a channel is formed on the first crystal surface of the top surface and the second crystal surface of the side surface of the projecting portion, and the channel width of the MIS field-effect transistor is at least a total of the channel width of the top surface and the channel width of the side surface.

With the above-mentioned configuration, since a channel is formed on two crystal surfaces, the characteristic of the MIS field-effect transistor and the current drive capability can be improved.

In the above-mentioned invention, the projecting portion has a top silicon surface (100) and the side silicon surface (110), with the source and the drain formed in the left and right areas of the projecting portion and the projecting portion of the silicon substrate enclosing the gate.

With the above-mentioned configuration, a channel can be formed on the surfaces (100) and (110) of the silicon substrate. Therefore, the current drive capability of the field-effect transistor can be improved.

In the above-mentioned invention, the DC amplifier includes a p-channel MIS field-effect transistor and a n-channel MIS field-effect transistor, and the gate width of the top surface and the side surface of the projecting portion of the p-channel MIS field-effect transistor is set such that the current drive capability of the p-channel MIS field-effect transistor can be substantially equal to the current drive capability of the n-channel MIS field-effect transistor.

With that configuration, the parasitic capacity of the p-channel MIS field-effect transistor can be substantially equal to the parasitic capacity of the n-channel MIS field-effect transistor. Consequently, the features of the DC amplifier can be improved, and the noise can be reduced during switching.

In the present invention, the DC amplifier includes first and second MIS field-effect transistors for differential amplification of an input signal, and a third MIS field-effect transistor commonly connected to the source or drain of the first and second MIS field-effect transistors and configuring a constant current circuit.

The above-mentioned invention also includes a fourth and fifth MIS field-effect transistors connected between the source or the drain of the first and second MIS field-effect transistors and the power source, and configures a constant current circuit as a load of the first and second MIS field-effect transistors.

With the above-mentioned configuration, the DC offset of the differential amplification circuit including the first and second MIS field-effect transistors, the constant current circuit including the third MIS field-effect transistor, or the constant current circuit including the fourth and fifth MIS field-effect transistors can be reduced: Furthermore, the influence of the channel length modulation effect in the circuits can also be reduced.

The semiconductor integrated circuit according to the present invention includes on the same circuit substrate: a circuit including a p-channel MIS field-effect transistor and a n-channel MIS field-effect transistor in which a projecting portion is formed by a silicon substrate having a first crystal surface as a primary surface and a second crystal surface as a side surface, terminal hydrogen on the silicon surface is removed in plasma atmosphere of an inert gas, then a gate insulating film is formed on at least a part of the top surface and the side surface of the projecting portion at a temperature equal to or lower than about 550°C in the plasma atmosphere, a gate is formed on the gate insulating film, and a drain and a source are formed on both sides enclosing the gate insulating film of the projecting portion; and a DC amplifier having a differential amplification circuit including the p-channel MIS field-effect transistor or the n-channel MIS field-effect transistor.

According to the invention, by reducing the variance of the characteristic of the MIS field-effect transistor (for example, a threshold voltage, etc.), the DC offset and the 1/f noise can be reduced. Thus, the gain of the DC amplifier can be enhanced, and the frequency characteristic of the DC amplifier can be improved, thereby requiring no additional circuit for compensating for the DC offset.

Furthermore, forming the gate in a three-dimensional structure and creating the gate insulating film in the low temperature plasma atmosphere causes the influence of the channel length modulation effect can be suppressed and the signal distortion in the DC amplifier to be decreased.

Also, using the above-mentioned p-channel MIS field-effect transistor and the n-channel MIS field-effect transistor for the circuit other than the DC amplifier, the distortion of the signal in the circuit can be reduced. Furthermore, the 1/f noise and the DC offset can also be reduced.

In the above-mentioned invention, the DC amplifier is configured by a CMOS circuit including the p-channel MIS field-effect transistor and the n-channel MIS field-effect transistor.

With the above-mentioned configuration, the current drive capability of the p-channel MIS field-effect transistor can be substantially equal to the current drive capability of the n-channel MIS field-effect transistor. Thus, the noise during switching can be symmetric between the positive and negative fields.

### Brief Description of the Drawings

Fig. 1 is a sectional view of the plasma device using a radial line slot antenna;
Fig. 2 shows the comparison of the interface level density;
Fig. 3 shows the structure of a silicon substrate produced in the semiconductor producing process according to an embodiment of the present invention;
Fig. 4 shows the structure of the MOS transistor produced in the semiconductor production process according to an embodiment of the present invention;
Fig. 5 shows the receiving circuit in the direct conversion system;
Fig. 6 shows the circuit of a DC amplifier; and
Fig. 7 shows the conventional DC amplifier.

### Best Mode for Carrying Out the Invention

An embodiment of the present invention is explained below with reference to the attached drawings. First, there is a semiconductor production process of forming a gate insulating film (for example, an oxide film) on the silicon substrate at a low temperature using an inert gas in a plasma state, and then the production of a MIS (metal insulator semiconductor) field-effect transistor. The method for forming a gate insulating film is disclosed in Japanese Published Patent Application No. 2002-261091.

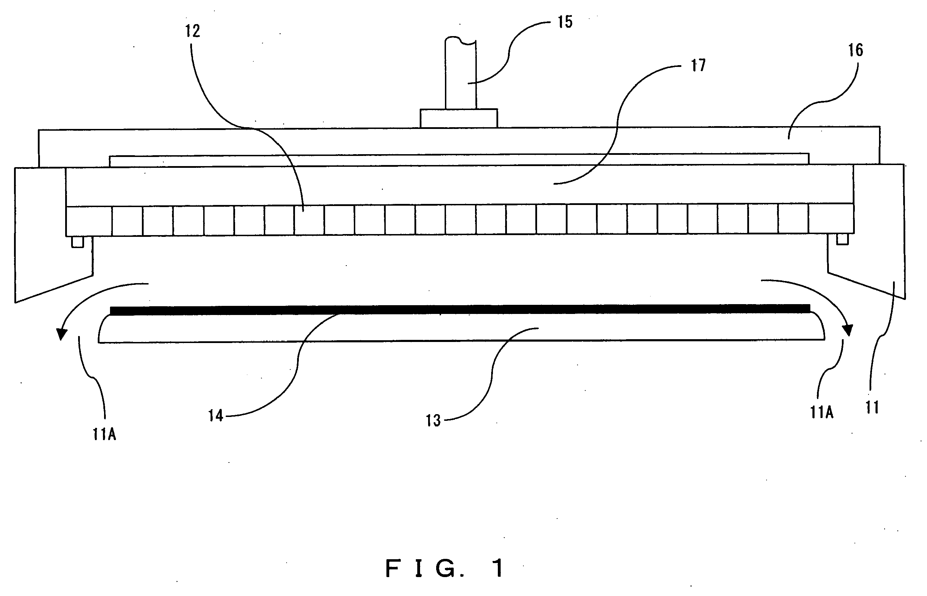

Fig. 1 is a sectional view of the plasma device with a radial line slot antenna to be used in the semiconductor production process.

A vacuum is created in a vacuum container (processing chamber) 11 and argon gas (Ar) is introduced from a shower plate 12. The Ar gas is exhausted from an outlet 11A, and then the gas is switched to a krypton gas (Kr). The pressure in the processing chamber 11 is set at 133 Pa (1 Torr).

Then, a silicon substrate 14 is placed on a sample table 13, which has a heating mechanism, and the temperature of a sample is set to approximately 400°C. If the temperature of the silicon substrate 14 is between 200°C and 550°C, following result is almost the same.

The silicon substrate 14 is cleansed with noble fluoride acid in the pretreatment process performed immediately before, and the unused coupling of silicon on the surface is terminated with hydrogen as a result.

Next, a frequency of 2.45 GHz microwave is supplied from a coaxial waveguide 15 to a radial line slot antenna 16, and then microwave is introduced from the radial line slot antenna 16 to the processing chamber 11 through a dielectric plate 17 provided in a portion of the wall. The introduced microwave pumps the Kr gas from the shower plate 12 to the processing chamber 11. As a result, a high density Kr plasma is formed immediately below the shower plate 12. If the frequency of the provided microwave is approximately between 900 MHz and 10 GHz, the following results are almost the same.

With the configuration shown in Fig. 1, the interval between the shower plate 12 and the silicon substrate 14 is approximately 6 cm. The film can be formed at a higher speed with the smaller interval.

The plasma can be pumped by introducing the microwave to the processing chamber using another method as described below, without limiting the plasma device to a device using a radial line slot antenna.

By exposing the silicon substrate 14 to the plasma pumped by the Kr gas, the surface of the silicon substrate 14 receives an irradiation of Kr ions of low energy, and the surface terminated hydrogen is removed.

Then, Kr/O₂ mixed gas having a partial pressure ratio of 97/3 is introduced from the shower plate 12. At this time, the pressure in the processing chamber is to be kept at approximately 133 Pa (1 Torr). In the high density pumped plasma, which is a mixture of a Kr gas and an O₂ gas, the Kr* and the O₂ molecules in the intermediate pumped state conflict with each other, and a large amount of atomic oxygen O* is efficiently generated.

In the present embodiment, the atomic oxygen O* oxidizes the surface of the silicon substrate 14. However, in the conventional thermal oxidation method, oxidation is performed by an O₂ molecule and an H₂O molecule, and a very high process temperature of over 800 °C is required. In the oxidization process using the atomic oxygen performed in the present embodiment, the oxidization process can be performed at a very low temperature of approximately 400°C. To extend the conflict opportunity between Kr* and O₂, it is desired that a higher pressure is kept in the processing chamber. However, if the pressure is too high, the generated O* conflicts with each other and is returned to an O₂ molecule state. Therefore, the optimum gas pressure must be maintained.

When the desired silicon oxide film (silicon compound layer) thickness is formed, the introduction of microwave power is stopped in order to terminate the plasma pumping. Then the Kr/O₂ gas mixture is replaced with Ar gas, thereby terminating the oxidization process. The Ar gas used before and after the present process, is a less expensive alternative to using Kr as a purge gas. The Kr gas used in this process can be collected for recycling.

After forming the above-mentioned oxide film, an electrode forming process a protective film forming process, hydrogen sintering process, etc. are performed to generate a semiconductor integrated circuit including a transistor and a capacitor.

A result of the above-mentioned procedure, the hydrogen content in the silicon oxide film is lower than 10¹² /cm² in the surface density conversion on the silicon oxide film of the film thickness of 3nm. Especially on the oxide film having a small leak current, the hydrogen content in the silicon oxide film is 10¹¹/cm² or less in the surface density conversion. On the other hand, the oxide film not exposed to the Kr plasma before forming the oxide film contains hydrogen of 10¹²/cm² or more in the surface density conversion.

When the oxidization process is performed with the Kr/O₂ gas introduced after removing the terminated hydrogen by irradiation with Kr plasma as described above, a very excellent low leak feature is obtained. The leak current at the same voltage as the silicon oxide film formed by the conventional microwave plasma oxidization is reduced by two or three digits of the leak current. The improvement of the leak current feature has been confirmed in the production of an integrated circuit using the silicon oxide film having the film thickness up to about 1.7 nm.

When the surface direction dependency of the silicon/silicon oxide film interface level density is measured relating to the silicon oxide film obtained in the above-mentioned semiconductor producing process, a very low interface level density of about 1 x 10¹⁰ eV⁻¹ cm⁻² is obtained any of the surface direction of the silicon surface.

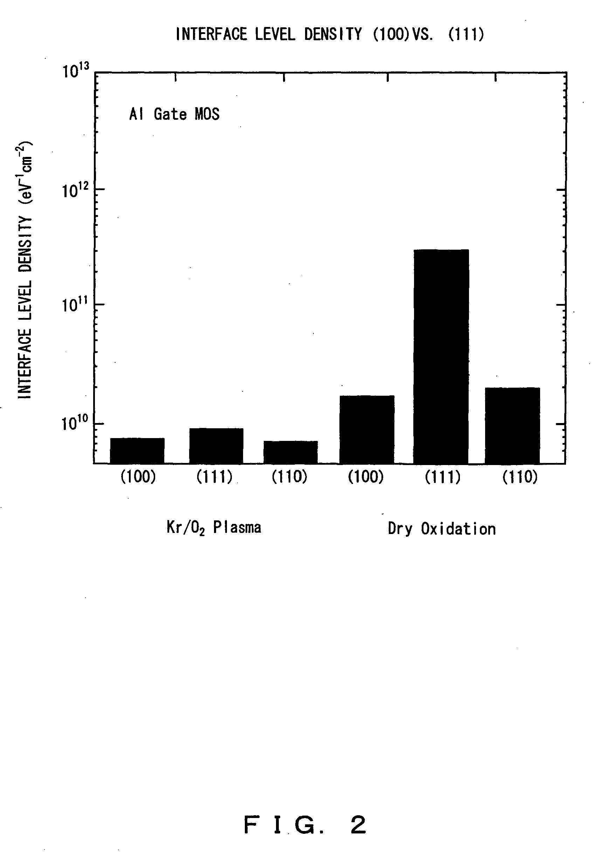

Fig. 2 shows the Kr/O₂ film formed by the above-mentioned semiconductor production process on each of the surfaces (100), (110), and (111) of a silicon substrate, and the results of measuring the interface level density of the conventional thermal oxide film.

As shown in Fig. 2, when the Kr/O₂ film is generated, the interface level density of the semiconductor on any of the surfaces (100), (110), and (111) is 10¹⁰ eV⁻¹ cm⁻² or lower. On the other hand, the interface level density of the conventional thermal oxide film formed in an atmosphere higher than 800°C is 1.1 times or more on surface (100), and in the above-mentioned semiconductor production process, a high quality insulating film of a low interface level density can be formed.

By lowering the interface level density, the probability of recombining a carrier can be reduced, thereby lowering the 1/f noise.

As to the electric features such as the pressure-resistant feature, the hot carrier resistance, the electric charge QBD (charge-to-breakdown) up to the destruction of the silicon oxide film when a stress current flows, etc. and the reliability feature, the oxide film formed in the semiconductor production process possesses qualities equivalent to or higher than the conventional thermal oxide film.

As described above, by performing the high grade silicon oxidization process in all surface directions at a low temperature (400°C) using the silicon oxidization process with Kr/O₂ high density plasma after removing the surface terminated hydrogen, it is considered that the above-mentioned effect can be obtained by a decreasing hydrogen content in the oxide film by removing the terminated hydrogen, and by containing an inert gas (Kr for example) in the oxide film. By having a small amount of hydrogen in the oxide film, there is no weak coupling of elements in the silicon oxide film, and by containing Kr, the stress in the film or on the Si/SiO₂ interface is moderated and charge in the film and the interface level density is reduced. As a result, the electric characteristic of the silicon oxide film can be largely improved.

In the above-mentioned semiconductor production process, it is considered that the hydrogen density of 10¹²/cm² or less in the surface density conversion, or 10¹¹/cm² or less as a preferred condition, and containing Kr 5 x 10¹¹ /cm² or less contributes to the improvement of the electric characteristics and reliability characteristics of the silicon oxide film.

In the above-mentioned semiconductor process, a silicon nitride film and a silicon oxide and nitride film can be formed using a mixture of an inert gas and a NH₃ gas and a mixture of an inert gas, O₂, and NH₃.

The effect obtained by forming a nitride film is mainly based on the presence of hydrogen in plasma even after removing the surface terminated hydrogen. By containing hydrogen in the plasma, the dangling bond in the silicon nitride film and on the interface forms a coupling of Si-H and N-H and is terminated, and as a result, the electronic trap in the silicon nitride film and on the interface disappear.

It is considered that the effect obtained by forming an oxide and nitride film is caused not only by the decrease in the hydrogen content in the oxide and nitride film by removing the terminated hydrogen, but also by some percentage of nitrogen contained in the oxide and nitride film. The Kr content in the oxide and nitride film is 1/10th or less of the content in the oxide film, and the content of nitrogen is larger than that of Kr. Since the hydrogen content is small in the oxide and nitride film, the rate of weak couplings in the silicon nitride film decreases, and the contained nitrogen moderates the stress in the film, Si/SiO₂, or on the interface. As a result, it is considered that the charge in the film and the interface level density decreases, and the electric characteristic of the oxide and nitride film is largely improved.

The desired result obtained by forming an oxide film or an oxide and nitride film is not only caused by removing the terminated hydrogen, but is also caused by containing Ar or Kr in the nitride film or the oxide and nitride film. That is, as a result of the above-mentioned semiconductor production process, the Ar or Kr contained in the nitride film moderates the stress on the silicon/nitride film interface. Consequently, the fixed charge in the silicon nitride film and the interface level density are reduced, and the electric characteristic, especially the 1/f noise, is reduced, thereby largely improving the reliability.

The inert gas used in the above-mentioned semiconductor production process is not limited to Ar gas, and Kr gas, but xenon gas Xe can also be used.

Furthermore, after forming a silicon oxide film and a silicon nitride film, the pressure in a vacuum container 1 is maintained at 133 Pa (1 Torr), a gas of a mixture of Kr/NH₃ at a partial pressure ratio of 98/2 is introduced, and a silicon nitride film of about 0.7 nm can be formed on the surfaces of a silicon oxide film and a silicon oxide and nitride film.

Thus, a silicon oxide film having a silicon nitride film formed on the surface, or a silicon oxide and nitride film can be obtained. Therefore, an insulating film having a high dielectric constant can be formed.

To realize the above-mentioned semiconductor production process, in addition to the device shown in Fig. 1, another plasma process device capable of forming a low temperature oxide film can be used. For example, it is possible to use a 2-stage shower plate type plasma process device having the first gas emission structure emitting an Ar or Kr gas for pumping plasma, and a second gas emission structure, which is different from the first gas emission structure and emits an O₂, NH₃, or N_{2/}H₂ gas.

Described below is the semiconductor production process according to an embodiment of the present invention. The semiconductor process forms a gate insulating film of a MIS field-effect transistor on the surface (100) and the surface (110).

When a p-channel transistor is formed on the surface (111), 1.3 times the current drive capability of the surface (100) is obtained. If it is formed on the surface (110), 1.8 times the current drive capability of the surface (100) is obtained.

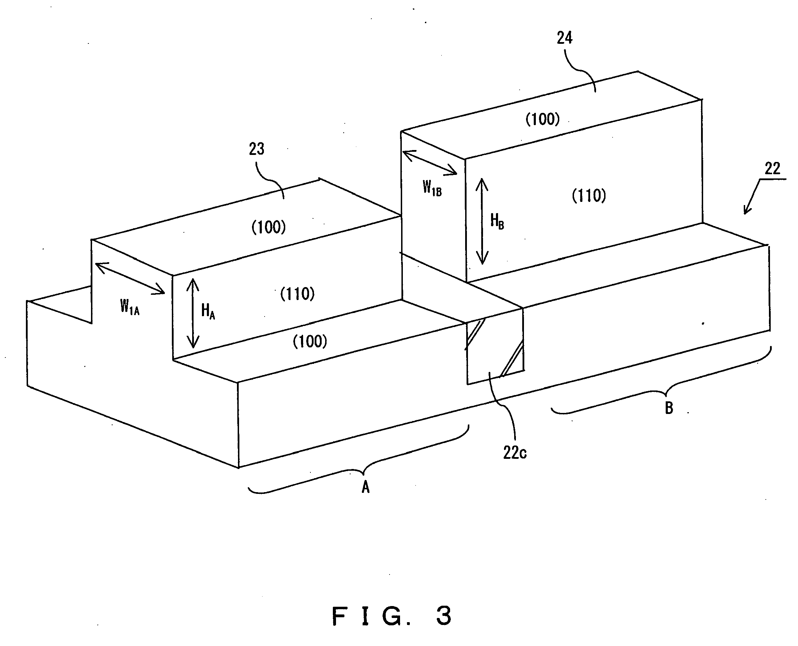

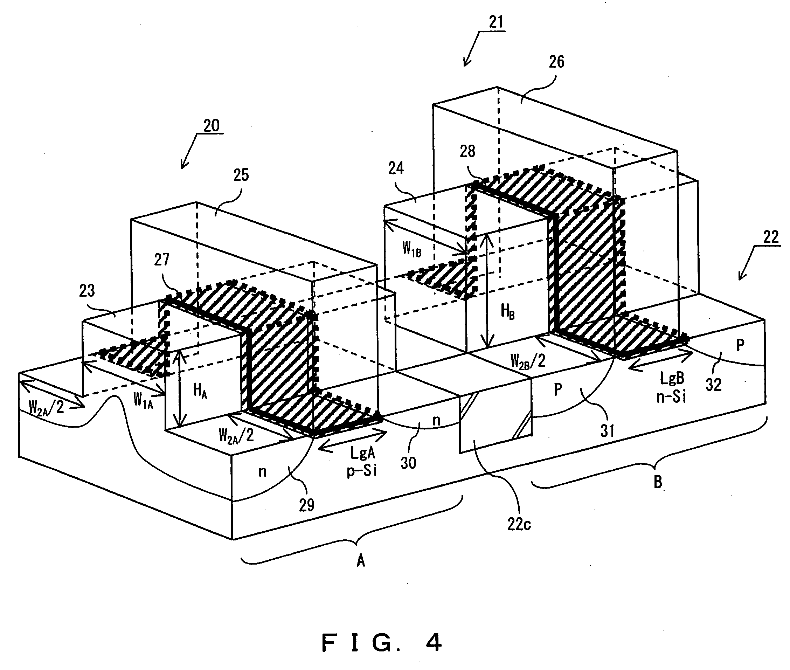

Fig. 3 shows the state of forming projecting portions 23 and 24 having surfaces (100) and (110) on a silicon substrate 22 in the semiconductor production process according to an embodiment of the present invention. Fig. 4 shows the structures of an n-channel MOS transistor 20 and a p-channel MOS transistor 21 produced in the semiconductor production process according to an embodiment of the present invention. Fig. 4 shows a channel formed at the lower portion of the gate oxide film and is indicated by diagonal lines.

As shown in Fig. 3, the silicon substrate 22 having the surface (100) as a primary surface is separated by a device separation area 22c into two areas: p-type area A and n-type area B. In area A, the rectangular parallelepiped projecting portion 23 having a height of H_{A} and a width of W_{1A} is formed on the reference of the surface (100). Similarly, in area B, the projecting portion 24 having a height of H_{B} and a width of W_{1B} is formed.

As shown in Fig. 4, a silicon oxide film is formed by the semiconductor production process on the surface of the silicon substrate 22 and the top surfaces and the side surfaces of the projecting portions 23 and 24.

On the silicon oxide film, polysilicon gate electrodes 25 and 26 are formed, the silicon oxide film is patterned when the polysilicon gate electrodes 25 and 26 are formed, and gate insulating films 27 and 28 are formed below the polysilicon gate electrodes 25 and 26.

In addition, an n-type impure ion is injected into the areas on both sides of the gate electrode 25 of the p-type area A, thereby forming n-type diffusion areas 29 and 30 including the projecting portion 23. The n-type diffusion areas 29 and 30 configure the source and the drain of the n-channel MOS transistor 20. Also, in the n-type area B, a p-type impure ion is injected into the areas on both sides of the gate electrode 26, thereby forming p-type diffusion areas 31 and 32 including the projecting portion 24. The p-type diffusion areas 31 and 32 configure the source and drain of the p-channel MOS transistor 21.

When a predetermined voltage is applied to the gate electrodes 25 and 26 of the p-channel MOS transistor 21 and the n-channel MOS transistor 20, a channel indicated by the diagonal lines shown in Fig. 4 is formed below the gate oxide films 27 and 28.

The gate width of the surface (100) of the n-channel MOS transistor 20 is the sum of W_{1A} on the top surface (top surface of the projecting portion 23) of the projecting portion 23, and W_{2A}/2 on the flat portions of the silicon substrate 22 on the right and left below the projecting portion 23. Therefore, it is a total of W_{1A} + W_{2A}. Similarly, the gate width of the surface (110) of the n-channel MOS transistor 20, that is, the gate widths of the left and right side surfaces of the projecting portion 23 are H_{A}. Therefore, it is a sum total of 2H_{A}. The gate width corresponds to the channel width. The gate length of the n-channel MOS transistor 20 is LgA.

Accordingly, the current drive capability of the n-channel MOS transistor 20 is expressed by µₙ₁ (W_{1A} + W_{2A}) + µₙ₂· 2H_{A}. µₙ₁ indicates the electron mobility on the surface (100) and µₙ₂ indicates electron mobility on the surface (110).

Similarly, the gate width of the surface (100) of the p-channel MOS transistor 21 is the sum of W_{1B} on the top surface of the projecting portion 24, and W_{2B}/2 at the flat portions of the silicon substrate 22 on the left and right below the projecting portion 24 respectively. Therefore, it is a total of W_{1B} + W_{2B}. The gate width of the surface (110) of the p-channel MOS transistor 21, that is, the gate widths on the left and right side surfaces of the projecting portion 24 are H_{B}. As a result, the gate width is a sum total of 2H_{B}. The gate width corresponds to the channel width. The gate length of the p-channel MOS transistor 21 is LgB.

Therefore, the current drive capability of the p-channel MOS transistor 21 can be expressed by µₚ₁ (W_{1B} + W_{2B}) + µₚ₂· 2H_{B}. µ_{P1} indicates the Hall mobility on the surface (100), and µₚ₂ indicates the Hall mobility on the surface (110).

Thus, by setting the respective heights H_{A} and H_{B} of the projecting portions 23 and 24, the current drive capability of the p-channel MOS transistor 21 and the current drive capability of the n-channel MOS transistor 20 can be balanced. This condition can be expressed by the following equation. µₙ₁ (W_{1A} + W_{2A}) + µₙ₂· 2H_{A} = µₚ₁ (W_{1B} + W_{2B}) + µₚ₂· 2 H_{B}

By setting the H_{A} and H_{B} to the values satisfying the equation above, the current drive capability of the p-channel MOS transistor 21 and the current drive capability of the n-channel MOS transistor 20 can be balanced. In this case, it is not necessary that the channel width of the primary surface (for example, the surface (100)) of the p-channel MOS transistor 21 is to be exceedingly larger than the channel width on the surface (100) of the n-channel MOS transistor 20. Therefore, the difference between them in parasitic capacity by a gate insulating film can be smaller. Thus, when a circuit of a CMOS structure is configured using p-channel MOS transistor 21 and n-channel MOS transistor 20, making their parasitic capacity nearly equal, the current value imbalance caused when the parasitic capacity by the gate oxide film of them is charged or discharged can be reduced, and the noise level caused when the transistor of the CMOS structure is switched can be lowered.

The height H_{B} of the p-channel MOS transistor 21 can be set such that, after setting the height H_{A} of the gate of the n-channel MOS transistor 20 to "0", the current drive capability of the p-channel MOS transistor 21 can be substantially equal to the current drive capability of the n-channel MOS transistor 20.

Since the area of the gate on the primary surface (for example, the surface (100)) of the silicon substrate of the p-channel or the n-channel MOS transistor can be smaller than in the conventional semiconductor producing process when the p-channel MOS transistor 21 or the n-channel MOS transistor 20 is individually formed, the area on the primary surface on the silicon substrate of the p-channel MOS transistor and the n-channel MOS transistor can be smaller, thereby enhancing the integration of a semiconductor circuit. Furthermore, since the parasitic capacities of the p-channel and N-channel MOS transistors can be made smaller, the switching speed of the MOS transistors can be increased, and the power consumption at the switch can be reduced.

The insulating film formed on the silicon surface is not solely limited to an oxide film, but a silicon nitride film, a silicon oxide and nitride film, etc. can also be formed.

Described below is the case where a semiconductor integrated circuit for a direct conversion receiver is produced in the semiconductor process according to the above-mentioned embodiment.

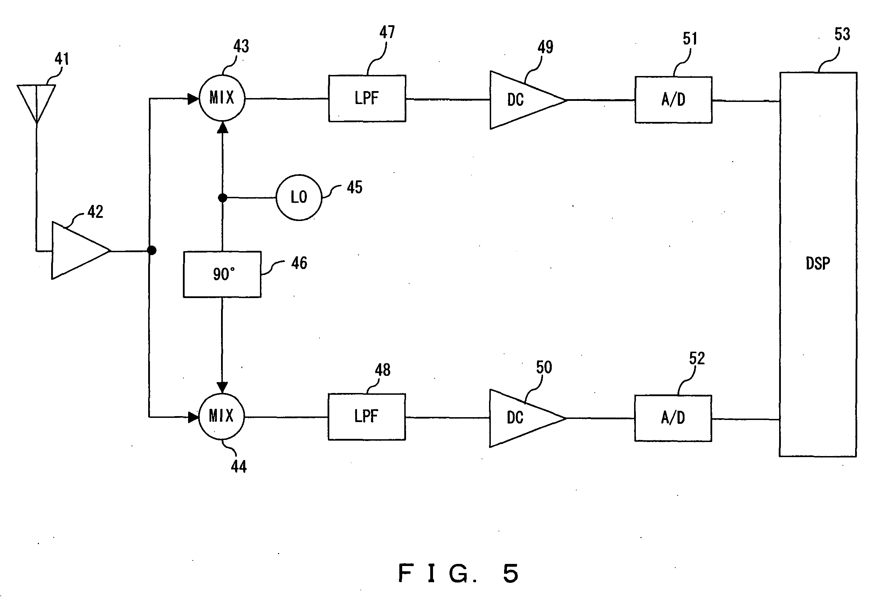

Fig. 5 shows the important portion of the circuit of the direct conversion receiver.

A radio signal received by the antenna 41 is amplified by the low noise amplifier 42, and inputted to the mixer circuits 43 and 44.

A local signal generated by the local oscillation circuit 45 is inputted to the other input terminal of the mixer circuit 43, and the local signal is 90 degrees phase-shifted by the phase shifter 46 and the obtained local signal is inputted to the other input terminal of the mixer circuit 44.

In the mixer circuits 43 and 44, the received signals and their local signals are mixed, and are converted to baseband signals having a 90 degree phase shift. Then, the low pass filters 47 and 48 formed by a switched capacitor filter, etc. attenuate a signal over a predetermined frequency, and output a resultant signal to the DC amplifiers 49 and 50.

The DC amplifiers 49 and 50 can perform amplification from a direct component, and amplify an input signal to the signal level depending on the resolution of the A/D converters 51 and 52.

The A/D converters 51 and 52 convert an analog baseband signal to a digital signal, and output the signal to the digital signal processor (DSP) 53.

The DSP 53 performs digital signal processing and demodulates the signal.

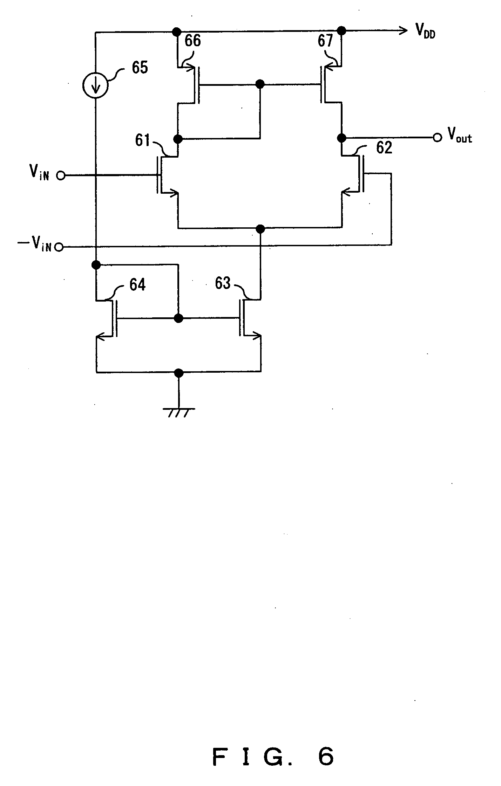

An example of DC amplifiers 49 and 50 is explained below and refers to Fig. 6.

The n-channel MOS transistors 61 and 62 configure a differential amplification circuit, a signal Vin output from the low pass filter 47 or 48 is inputted to the gate of the n-channel MOS transistors 61, and a signal -Vin is inputted to the gate of MOS transistor 62.

The n-channel MOS transistor 63 and the n-channel MOS transistor 64 configure a current mirror circuit, and the drain of the MOS transistor 63 is commonly connected to the source of the MOS transistors 61 and 62. The drain of the MOS transistor 64 is connected to the power source voltage VDD through the constant current source 65, and the gate of the MOS transistors 63 and 64 is connected to the drain of the MOS transistor 64.

Since the MOS transistors 63 and 64 configure a constant current circuit, and the constant current source 65 is connected to the drain of the MOS transistor 64, a constant current proportional to the current supplied from the constant current source 65 flows through the MOS transistor 63.

The MOS transistors 66 and 67 configure a current mirror circuit, where the source is connected to the power source voltage VDD, and the drain is connected to the drain of each of the MOS transistors 61 and 62. The gates of the MOS transistors 66 and 67 are connected to the drain of the MOS transistor 66. The MOS transistors 66 and 67 function as a load of the MOS transistors 61 and 62.

A DC amplifier comprised of the above-mentioned differential amplification circuit performs differential amplification on the input signals Vin and -Vin using the MOS transistors 61 and 62, and the amplified signal, Vo, is output.

By structuring the gate of the MOS transistor of the DC amplifier in a three-dimensional array and forming a gate oxide film in a low temperature plasma atmosphere, the influence of the channel length modulation effect of the differential amplification circuit comprised of the MOS transistors 61 and 62 can be reduced, and the distortion of a signal in the differential amplification circuit is decreased. Furthermore, since the influence of the constant current (comprised of the MOS transistors 66 and 67) at the drain functioning as a load of the differential amplification circuit and the channel length modulation effect of the constant current circuit (comprised of the MOS transistors 63 and 64) at the source, the fluctuation of the drain current in these circuits can be reduced.

As described above, eliminating the damage of the silicon surface and leveling the surface can reduce the variance of the characteristics (for example, in threshold voltage, etc.) of the MOS transistors. Therefore, the DC offset of the entire circuit can be reduced. Thus, devices (a circuit, a capacitor, etc.) for removing the DC offset are not required, and the signal gain of the DC amplifier can be enhanced. By enhancing the signal gain of the DC amplifier, for example, a low resolution D/A converter can be used for the A/D converter at the subsequent stage of the DC amplifier of the receiving circuit in the direct conversion system.

Furthermore, by removing the terminated hydrogen on the silicon surface in a plasma atmosphere such as argon, etc. and then forming a thin and flat silicon insulating film in a plasma atmosphere including argon, krypton, or xenon including oxygen and a gaseous molecule such as oxygen, nitrogen, etc. and at a lower temperature of 550°C or less, the interface level density of the silicon surface can be lowered. Thus, the probability of recombination of a carrier can be reduced and the 1/f noise is decreased. By decreasing the 1/f noise, the S/N ratio of the signal downconverted by the mixer circuits 43 and 44 can be improved. As a result, the gain of the DC amplifier can be increased.

Additionally, since the current drive capability of the MOS transistor can be improved and the device area can be made smaller, the integration can be enhanced, and the operation speed can be increased. Furthermore, a large signal gain can be obtained since the operation characteristic of the field-effect transistor of a DC amplifier is prepared, the parasitic capacity can be reduced, the frequency characteristic of the differential amplification circuit can be improved, and a DC offset can be reduced. Thus, since the DC offset and the 1/f noise can be reduced, it is particularly effective for a DC amplifier in the direct conversion system where a received signal is directly converted to an audio signal.

A CMOS circuit comprised of an n-channel MOS transistor and a p-channel MOS transistor can also configure a DC amplifier. In this case, the parasitic capacity of the p-channel MOS transistor can be substantially equal to the parasitic capacity of the n-channel MOS transistor, and the parasitic capacity can be smaller, thereby increasing the operation speed, etc. of a circuit. Additionally, the noise caused by the imbalance of a current when a p-channel MOS transistor and an n-channel MOS transistor are turned ON or OFF can be decreased.

The p-channel MOS transistor and the n-channel MOS transistor used in the frequency conversion circuit, the A/D conversion circuit, the digital circuit, etc. other than the DC amplifier can be produced in the above-mentioned semiconductor process.

With the above-mentioned configuration, since the characteristics of the p-channel MOS transistor and the n-channel MOS transistor of other circuits can be prepared, a DC offset and 1/f noise can be reduced. Additionally, since the current drive capability of the MOS transistor can be improved, the operation characteristics of a circuit can be improved.

Furthermore, the channels of the p-channel MOS transistors and the n-channel MOS transistors of the DC amplifier or other circuits are formed on different crystal surfaces (for example, the surfaces (100) and (110)) of silicon, and the channel width can be designed such that the current drive capability of a p-channel MOS transistor can be substantially equal to the current drive capability of a n-channel MOS transistor.

With the configuration, the parasitic capacity of the p-channel MOS transistor can be substantially equal to the parasitic capacity of the n-channel MOS transistor. Accordingly, the switching characteristic can be improved, and the noise generated by a current when the MOS transistors are turned ON or OFF can be reduced.

The present invention is not limited to the above-mentioned embodiments but can also be configured as follows.

The DC amplifier according to the present invention is not limited to the circuit in the direct conversion system, but can be applied to other circuits. The DC amplifier is not limited to the differential amplification circuit according to the above-mentioned embodiments, but can also be an amplification circuit of other configurations.

The crystal surface of silicon is not limited to a combination of the surfaces (100) and (110), but can be a combination with another crystal surface such as the surfaces (100) and (111).

According to the present invention, the DC offset and the 1/f noise of the DC amplifier can be reduced. Therefore, a circuit for compensating for a DC offset is not required. Furthermore, since the 1/f noise is reduced, the frequency characteristic of the DC amplifier can be improved. Additionally, the influence of the channel length modulation effect and the distortion of a signal in the DC amplifier can also be reduced.

## Claims

1. A DC amplifier formed on a substrate of a semiconductor integrated circuit, comprising
a differential amplification circuit including a MIS field-effect transistor in which a projecting portion is formed by a silicon substrate having a first crystal surface as a primary surface and a second crystal surface as a side surface, terminated hydrogen on the silicon surface is removed in plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion.

2. The DC amplifier according to claim 1, wherein
a channel is formed on the first crystal surface of a top surface and the second crystal surface of the side surface of the projecting portion, and the channel width of the MIS field-effect transistor is a total of a channel width of the top surface and a channel width of the side surface.

3. The DC amplifier according to claim 1 or 2, wherein
the projecting portion has the top surface comprising a silicon surface (100), the side surface comprising a silicon surface (110), and the source and drain are formed on the projecting portion enclosing the gate and in left and right areas of the projecting portion of the silicon substrate.

4. The DC amplifier according to claim 1 or 2, further comprising first and second MIS field-effect transistors for performing differential amplification on an input signal, and a third MIS field-effect transistor which is connected to a source or a drain of the first and second MIS field-effect transistors and configures a constant current circuit.

5. The DC amplifier according to claim 4, further comprising fourth and fifth MIS field-effect transistors which are connected between a source or a drain of the first and second MIS field-effect transistors and configure a constant current circuit as a load of the first and second MIS field-effect transistors.

6. A semiconductor integrated circuit, comprising on a same circuit substrate:
a circuit including a p-channel MIS field-effect transistor and an n-channel MIS field-effect transistor in which a projecting portion is formed by a silicon substrate having a first crystal surface as a primary surface and a second crystal surface as a side surface, terminated hydrogen on the silicon surface is removed in plasma atmosphere of an inert gas, then a gate insulating film is formed on at least a part of the top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and
a DC amplifier having a differential amplification circuit including the p-channel MIS field-effect transistor or the n-channel MIS field-effect transistor.

7. The semiconductor integrated circuit according to claim 6, wherein
gate widths of a top surface and a side surface of the p-channel MIS field-effect transistor and the n-channel MIS field-effect transistor are set such that the current drive capability of the p-channel MIS field-effect transistor can be substantially equal to current drive capability of the n-channel MIS field-effect transistor.

8. The semiconductor integrated circuit according to claim 6 or 7, wherein
the limiter circuit comprises a CMOS circuit having the p-channel MIS field-effect transistor and the n-channel MIS field-effect transistor.
